# EUROPÄISCHE PATENTSCHRIFT

(11) **EP 1 308 738 B1**
(45) Veröffentlichungstag und Bekanntmachung des Hinweises auf die Patenterteilung: **22.11.2006**
(21) Anmeldenummer: 02018993.2
(22) Anmeldetag: 27.08.2002
(51) Int. Cl.: G01R 31/36

(54) **Verfahren zur Bestimmung des Ladezustandes von Akkumulatoren durch Integration der bei Ladung und Entladung fliessenden Strommengen**
Procedure for determining the state of charge of accumulators by integration of the current amounts flowing during charge and discharge
Procédé de détermination de l'état de charge des accumulateurs par intégration des flux de courants pendant la charge et la décharge

(30) Priorität: 02.11.2001 DE 10153916
(43) Veröffentlichungstag der Anmeldung: 07.05.2003
(73) Patentinhaber: VARTA Automotive Systems GmbH, 30419 Hannover (DE)
(72) Erfinder: Ullrich, Matthias, Dr., 38518 Gifhorn (DE); Folge, Hans-Walter, 31228 Peine (DE); Schmitz, Claus, Dr., 59348 Lüdinghausen (DE)
(74) Vertreter: Lins, Edgar

(56) Entgegenhaltungen:
- US-A- 5 539 318
- US-A- 6 127 806
- US-A1- 2001 009 370
- PATENT ABSTRACTS OF JAPAN Bd. 2000, Nr. 21, 3. August 2001 (2001-08-03) & JP 2001 091604 A (HONDA MOTOR CO LTD), 6. April 2001 (2001-04-06)
- PATENT ABSTRACTS OF JAPAN Bd. 1999, Nr. 09, 30. Juli 1999 (1999-07-30) & JP 11 103505 A (NISSAN MOTOR CO LTD), 13. April 1999 (1999-04-13)

## Beschreibung

Die Erfindung betrifft ein Verfahren zur Bestimmung des Ladezustandes von Akkumulatoren durch Integration der bei Ladung und Entladung fließenden Strommengen.

Für zahlreiche Anwendungen von Akkumulatoren ist es erforderlich, den aktuellen Ladezustand zu ermitteln. Dazu stehen primär die Messgrößen Akkumulatorenstrom, Akkumulatorenspannung und Temperatur zur Verfügung. Bekannte Verfahren zur Bestimmung des Ladezustands verwenden insbesondere die Integration des durch den Akkumulator fließenden Stromes.

In dem US-Patent 6.127,806 ist ein Verfahren zur Bestimmung des Ladezustandes von Akkumulatoren durch Integration bei der Ladung und Entladung fließenden Strommengen beschrieben. Ein Ladezustandswert wird durch Messung einer Ruhespannung und Vergleich mit Ruhespannungskennlinien ermittelt. Eine Integration findet nur ausnahmsweise dann statt, wenn die Ruhespannung einer Zelle größer als diejenige Spannung ist, für die ein Ladezustandswert von 100 % festgelegt worden ist.

In der US 2001/009370 A1 ist ein Verfahren zur Bestimmung des Ladezustands eines Akkumulators beschrieben, bei dem der Ladezustand dadurch bestimmt wird, dass mindestens zwei Ladezustandswerte mit jeweils verschiedenen Verfahren bestimmt werden. Die so ermittelten einzelnen Ladezustandswerte werden mit Zuverlässigkeitsfaktoren gewichtet und ergeben auf diese Weise einen resultierenden Ladezustandswert für den Akkumulator.

Aus der DE-PS 22 42 510 ist es beispielsweise bekannt, bei einem Verfahren zur Messung des Ladezustands den Ladestrom mit einem von der Temperatur und vom Ladezustand der Batterie selbst abhängigen Faktor zu bewerten. In anderen Fällen wird der Vergleich zwischen Batteriespannung und einer bekannten Ruhespannungskennlinie, die einen eindeutigen Zusammenhang zwischen Ladezustand und Ruhespannung beschreibt, verwendet. So ist der DE-OS 40 07 883 ein Verfahren zu entnehmen, bei dem die Startfähigkeit eines Akkumulators durch Messung von Akkumulatorenspannung und Batterietemperatur und Vergleich mit einer für den zu prüfenden Batterietyp geltenden Ladezustandskurvenschar ermittelt wird.

Diese bekannten Verfahren haben wesentliche Nachteile. Bei der Ladungsbilanzierung führen Ungenauigkeiten in der Strommessung zu einem sich mit der Zeit akkumulierenden Fehler, der schnell zu einer wesentlichen Verfälschung der Ergebnisse führen kann. Darüber hinaus kann die stets vorhandene Selbstentladung des Akkumulators bei solchen Stromintegrationen nicht berücksichtigt werden. Die mit Kennlinien arbeitenden Verfahren haben Nachteile insbesondere bei sehr flachen U/Ladezustand-Kennlinien, da dann eine sehr genaue Spannungsmessung erforderlich und generell zusätzlich andere Faktoren wie die Höhe des Akkumulatorenstromes und die Temperatur berücksichtigt werden müssen. Bei Systemen mit nicht eindeutiger U/Ladezustand-Kennlinie ist eine Bestimmung des Ladezustands aus der Kennlinie allein nicht möglich. Dies gilt zum Beispiel für das System Nickel-Metallhydrid.

Die Nachteile dieser bekannten Methoden zur Bestimmung des Ladezustands treten umso deutlicher hervor, je dynamischer die Leistungsanforderung und je kleiner die Kapazität des Akkumulators ist. Dies ist aber insbesondere bei Batterieanwendungen wie zum Beispiel der Bordnetzbatterie oder der Hybridbatterie in Kraftfahrzeugen der Fall.

Der Erfindung liegt daher die Aufgabe zugrunde, ein Verfahren zur Ermittlung des Ladezustands eines Akkumulators, insbesondere eines Nickel-Metallhydrid-Akkumulators anzugeben, welches eine ausreichende Genauigkeit besitzt und eine zuverlässige Vorhersage des Ladezustands auch bei dynamischen Anwendungen ermöglicht.

Diese Aufgabe wird erfindungsgemäß bei einem eingangs genannten Verfahren zur Ermittlung des Ladezustands durch die kennzeichnenden Merkmale des Anspruchs 1 gelöst. In den Unteransprüchen sind vorteilhafte Ausgestaltungen des Verfahrens angegeben.

Im Folgenden ist das erfindungsgemäße Verfahren anhand einer Figur näher erläutert.

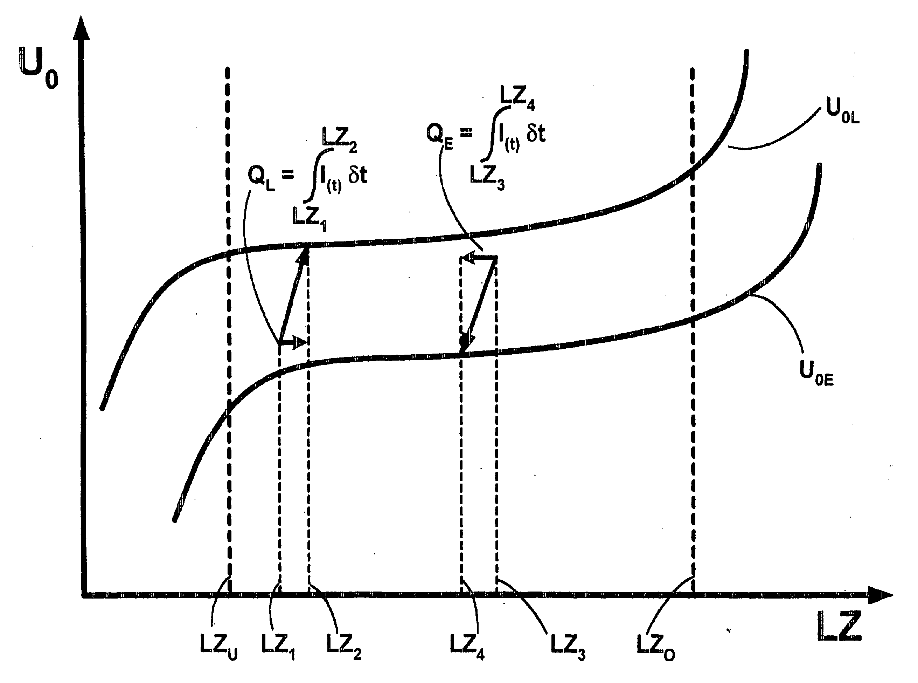

Die Figur zeigt den Verlauf der Ruhespannung eines Nickel-Metallhydrid-Akkumulators in Abhängigkeit vom Ladezustand.

Die Spannung U_{0L} ist daher die im stromlosen Zustand des Akkumulators gemessene Spannung, die sich nach Beendigung eines Ladungsvorgangs einstellt. Die Spannung U_{0E} ist die bei stromlosem Akkumulator gemessene Spannung, die sich nach Beendigung eines Entladevorganges einstellt.

Unter stromlos ist dabei und im Folgenden zu verstehen, dass der Strom sich im Bereich zwischen 0 und I₁₀ befindet, wobei I₁₀ dem Strom entspricht, der ausreichend ist, um einen Akkumulator in 10 Stunden auf seine Nennkapazität aufzuladen. Im Bereich zwischen diesen beiden Kennlinien besitzen die Elektroden ein sogenanntes Mischpotential, welches dadurch gekennzeichnet ist, dass es sich nicht um ein Gleichgewichtspotential, sondern um ein Ruhepotential handelt, mit unbestimmten Austauschstromdichten der Einzelreaktionen.

Erfindungsgemäß werden während des Betriebs der Batterie dauernd mehrere Ladezustandswerte LZ berechnet. Dabei wird ein erster Ladezustand LZ_{A}, der auch als buchhalterischer Ladezustand bezeichnet werden kann, aus der zeitlichen Integration des durch den Akkumulator fließenden Stromes ermittelt. Der durch diese Stromintegration ermittelte Wert kann durch Korrekturen verbessert werden. Beispielsweise kann der gemessene Akkumulatorenstrom mit einem Faktor η gewichtet werden, der einen Ladewirkungsgrad beschreibt, der selbst wieder abhängig ist vom Ladezustand, der Temperatur und dem Strom. Als weitere Korrektur wird die Selbstentladung des Akkumulators, die abhängig ist von Ladezustand und Temperatur, permanent vom durch Integration ermittelten Ladezustand abgezogen.

Daneben wird erfindungsgemäß ein weiterer Ladezustand LZ_{B} ermittelt, der aus einer Korrelation der lastfreien Spannungskennlinien ermittelt wird. Gemäß der Erfindung wird zur Ermittlung des zweiten Ladezustandswertes die Ruhespannung, die sich entweder nach Ladung einer definierten Ladungsmenge Q oder nach Entladung einer definierten Ladungsmenge Q aus dem Akkumulator einstellt, herangezogen. Diese Ladungsmenge Q muss stets ausreichend sein, um den Bereich des Mischpotentials der Elektroden zu verlassen und zu einer tatsächlichen Ruhespannung des Akkumulators zu gelangen. In der Figur sind beispielsweise eine Ladungsmenge Q_{L} (L_{Z1}, L_{Z2}) und eine Entladungsmenge Q_{E} (L_{Z3}, LZ₄) schematisch dargestellt. Wie bereits oben genannt, kann diese Ruhespannung auch bei noch innerhalb bestimmter Grenzen (I₁₀) vorhandenen Strömen gemessen werden. Diese so gemessene Ruhespannung kann dann durch Korrektur des gemessenen Spannungsabfalls um den Innenwiderstand der Batterie korrigiert werden, wobei der Innenwiderstand selbst abhängig ist vom Ladezustand und der Temperatur. Die so korrigierte Ruhespannung wird dann erfindungsgemäß mit empirisch ermittelten Ruhespannungskennlinien des Akkumulators verglichen und daraus wird der Ladezustand LZ_{B} ermittelt. Aus den so gewonnenen Werten des Ladezustands wird derjenige ausgewählt, der unter den vorangegangenen Betriebsbedingungen zuverlässiger ist. Dabei wird bei der Bewertung von LZ_{A} insbesondere der Ladungsdurchsatz bei der Bewertung von LZ_{B}, insbesondere die bei der Messung geflossene Ladungsmenge Q berücksichtigt.

Erfindungsgemäß ist es nicht notwendig, dass die Ladungsmenge Q sich aus einem ständig fließenden Ladestrom ergibt. Es ist auch möglich, dass dieser Ladestrom zum Beispiel durch kurze Entladeintervalle unterbrochen wird.

Es leiten sich daher zwei Möglichkeiten der Bestimmung der Ladungsmenge Q ab. In einem ersten Verfahren wird die Ladungsmenge Q durch zeitliche Integration des Lade- oder Entladestroms des Akkumulators bestimmt. Der Wert von Q sollte in diesem Verfahren erfindungsgemäß innerhalb eines Bereiches von 1 bis 40% der Nennkapazität der Batterie liegen, insbesondere sollte der Wert Q zwischen 5 und 10% der Nennkapazität der Batterie betragen. Wird bei Aufintegration von Q Ladung oder Entladung unterbrochen und die Batterie entladen oder geladen, so wird der Wert auf 0 zurückgesetzt und bei weiterer Ladung bzw. Entladung vom zurückgesetzten Wert aus erneut aufintegriert.

In einem zweiten Verfahren kann die Ladungsmenge Q bestimmt werden, ohne dass ständig ein in Lade- oder Entladerichtung fließender Strom vorhanden sein müsste, sondern der jeweilige Strom kann durch kurze Lade- oder Entladephasen unterbrochen werden. In diesem Fall wird eine zeitliche Integration des Akkumulatorstromes vorgenommen, wobei in die integrative Bestimmung von Q sowohl Lade- wie auch Entladevorgänge eingehen. In diesem Verfahren soll die Ladungsmenge Q zwischen 1 und 40%, vorzugsweise zwischen 5 bis 15%, der Nennkapazität des Akkumulators betragen.

Die Zuverlässigkeit der LZ_{B}-Werte, die aus den gemessenen U₀-Werten über die U₀/Ladezustandskennlinien ermittelt werden, hängt von verschiedenen Kriterien, insbesondere von Entlade- oder Lademenge, ab. Auch der durch Stromintegration ermittelte buchhalterische Ladezustand LZ_{A} ist mit einem Fehler versehen, welcher insbesondere mit der Zeit größer wird.

In einem Akkumulator, der mehr als ca. 20 Zellen besitzt, werden verschiedene Teilspannungen des gesamten Batterieverbandes gemessen. Aus der geringsten bzw. höchsten Teilspannung einer Akkumulatorenbatterie ergeben sich LZ_{Amin} und LZ_{Amax} sowie LZ_{Bmin} und LZ_{Bmax}-Werte. Diese verschiedenen Ladezustandswerte werden einzeln mit Zuverlässigkeitsfaktoren versehen. Die Zuverlässigkeitswerte werden für die verschiedenen Ladezustandswerte nach unterschiedlichen Verfahren ermittelt und normiert. Der Zuverlässigkeitswert für die buchhalterische, durch Stromintegration erfolgte Ladezustandsbestimmung hängt sehr stark von der Zeit seit einer letzten Kalibrierung ab, da alle Fehler bei der Bestimmung des Stromes und der Korrekturfaktoren zeitlich aufintegriert werden. Weitere Faktoren, die in die Zuverlässigkeit dieser Ladezustandsbestimmungsmethode einfließen, sind die durchgesetzte Ladungsmenge seit einer Re-Kalibrierung und der maximale Lade- bzw. Entladestrom und insbesondere die Batterietemperatur.

Die Zuverlässigkeit der aus der Messung der Ruhespannung bestimmten Ladezustandswerte wird anhand von Randbedingungen bestimmt. Dabei wird insbesondere darauf Rücksicht genommen, dass der Zusammenhang zwischen Ruhespannung und Ladezustand in bestimmten Bereichen zuverlässiger ist. Insbesondere soll der Ladezustand daher oberhalb von Werten zwischen 10 und 30% (L_{z0})und unterhalb von Werten zwischen 70 und 90% (L_{ZU}) liegen. Darüber hinaus sollen sich die Werte der Ladezustände, die aus Teilspannungen der Batterie ermittelt wurden, nur um bestimmte Größen unterscheiden, beispielsweise sollten die Unterschiede bei maximal ca. 5% liegen. Weiterhin wird der Absolutwert des durch die Batterie fließenden Stromes berücksichtigt, der innerhalb eines Zeitraums t fließt. Der Zeitraum t sollte kleiner sein als 20 Minuten, vorzugsweise liegt t zwischen 10 Sekunden und 3 Minuten. Der Stromgrenzwert I₁ soll kleiner sein als C/10 (I₁₀), vorzugsweise liegt I₁ zwischen C/100 und C/20.

Entsprechend den Abweichungen der Ist-Werte von den zuvor genannten Soll-Werten werden die ermittelten LZ_{A} - und LZ_{B}-Werte mit einer bestimmten Zuverlässigkeit bewertet. Die Zuverlässigkeit ist umso höher, je geringer die Abweichungen von den Grenzwerten sind. Der Ladezustand der Batterie wird dann aus den einzelnen LZ_{A}- und LZ_{B}-Werten ermittelt, wobei der Ladezustand mit der höchsten Zuverlässigkeit verwendet wird. Eine Korrektur des Ladezustands erfolgt zu festgelegten Zeiten, wenn beispielsweise zeitliche oder kapazitive Grenzwerte erreicht werden. Eine korrektive Anpassung des Ladezustands erfolgt erfindungsgemäß nur schrittweise. Wenn beispielsweise der alte und neue Ladezustand um weniger als 0 bis 10% abweichen, wird der alte Wert unverändert beibehalten, um Fehleraufsummierungen zu vermeiden. Ist der neue Ladezustand um mehr als 10% höher als der alte Ladezustand, so wird eine Korrektur um ca. 5 bis 20%, je nach Höhe der Differenz, vorgenommen, wobei allerdings eine erneute Korrektur erst nach Ablauf eines vorgegebenen Zeitraums erfolgen kann, der mindestens ca. 1 Minute, vorzugsweise 1 Minute bis 30 Minuten, beträgt. Ebenso wird verfahren, wenn der neue Ladezustand geringer ist als der vorhergehende Ladezustand.

## Patentansprüche

1. Verfahren zur Bestimmung des Ladezustandes von Akkumulatoren durch Integration der bei Ladung und Entladung fließenden Strommengen, wobei ein erster Ladezustandswert (LZ_{A}) durch ständige Integration des Akkumulatorenstroms ermittelt wird, und dass ein zweiter Ladezustandswert (LZ_{B}) durch Messung der Ruhespannung (U₀) nach Aufnahme oder Entnahme einer definierten Ladungsmenge (Q), die ausreichend ist, um den Bereich des Mischpotentials der Elektroden zu verlassen und zu einer Ruhespannung des Akkumulators zu gelangen und durch Vergleich dieser gemessenen Ruhespannung (Uo) mit empirisch bestimmten Ruhespannungs-Kennlinien des Akkumulators ermittelt wird, dass aus den so gewonnenen LZ-Werten derjenige ausgewählt wird, der unter den vorangegangenen Betriebsbedingungen zuverlässiger ist, wobei bei der Bewertung der Zuverlässigkeit von (LZ_{A}) insbesondere der Ladungsdurchsatz und bei der Bewertung der Zuverlässigkeit von (LZ_{B}) insbesondere die geflossene Ladungsmenge (Q) berücksichtigt werden, und die Ladungsmenge (Q) zwischen 1 bis 40 %, vorzugsweise 5 bis 15 %, der Nennkapazität des Akkumulators beträgt.

2. Verfahren nach Anspruch 1, **dadurch gekennzeichnet, dass** bei der Bewertung von (LZ_{A}) neben dem Ladungsdurchsatz die Zeit nach der letzten Kalibrierung berücksichtigt wird.

3. Verfahren nach den Ansprüchen 1 oder 2, **dadurch gekennzeichnet, dass** bei der Bewertung des zweiten Ladezustandswertes (LZ_{B}) die Höhe des bei der U₀₋Ermittlung noch fließenden Stromes berücksichtigt wird, wobei ein größerer Reststrom zur Annahme einer geringeren Zuverlässigkeit führt.

4. Verfahren nach einem oder mehreren der Ansprüche 1 bis 3, **dadurch gekennzeichnet, dass** bei der Bewertung des zweiten Ladezustandswertes (LZ_{B}) der Ladezustand des Akkumulators berücksichtigt wird, wobei Ladezustände zwischen 7D bis 90% und zwischen 30 bis 40 % eine höhere Zuverlässigkeit ergeben als übrige Ladezustände.

## Claims

1. Method for determining the state of charge of a rechargeable battery by integration of amounts of current flowing during charging and discharging, wherein a first state of charge value (LZ_{A}) is determined by continuous integration of the rechargeable battery current, and that a second state of charge value (LZ_{B}) is determined by measuring a voltage (U₀) under no load after receiving or supplying a selected amount of charge (Q) sufficient to leave a region of mixed potential of electrodes of the battery and reach a final no-load voltage of the rechargeable battery and by comparison of the measured no-load voltage (U₀) with empirically determined no-load voltage characteristics for the rechargeable battery, wherein out of the so obtained LZ-values those value IS selected, which is under the preceding conditions of use of higher reliability, wherein for accessing reliability of (LZ_{A}) especially the charge throughput and for accessing reliability of (LZ_{B}) especially the amount of charge (Q), which has flowed through the battery is considered and that the amount of charge (Q) is between about 1 to 40 % preferable 5 to 50 % of the rated capacity of the rechargeable battery.

2. Method according to claim 1, **characterized in that** in assessing of (LZ_{A}) the times since the most recent calibration is considered besides the charge throughput.

3. Method according to claims 1 or 2, **characterized in that** in assessing of the second state of charge value (LZ_{B}) the magnitude of current flowing during determination of U₀ is considered, wherein a greater residual current means lower reliability.

4. Method according to one or several of claims 1 to 3 **characterized in that** for a session of the second state of charge value (Lz_{B}) the state of charge of the rechargeable battery is considered, wherein states of charge between about 70 and about 90 % and between 30 and about 40 % indicating higher reliability than other states of charge.

## Revendications

1. Procédé de détermination de l'état de charge d'accumulateurs par intégration de quantités de courant lors de la charge et de la décharge, selon lequel on détermine une première valeur d'état de charge (LZ_{A}) par intégration permanente du courant d'accumulateur, et une deuxième valeur d'état de charge (LZ_{B}) par mesure de la tension de repos (Uo) après l'entrée ou la sortie d'une quantité de charge définie (Q) suffisante pour quitter la zone du potentiel mixte des électrodes et arriver à une tension de repos de l'accumulateur, et par comparaison de cette tension de repos (Uo) mesurée de l'accumulateur avec des lignes caractéristiques de la tension de repos de l'accumulateur déterminées de façon empirique, on choisit parmi les valeurs LZ ainsi obtenues celle qui dans les conditions de fonctionnement préalables est la plus fiable, et on prend en compte lors de l'évaluation de la fiabilité (LZ_{A}) en particulier le débit de charge et lors de l'évaluation de la fiabilité de (LZ_{B}) en particulier la quantité de charge (Q) écoulée, la quantité de charge (Q) se situant entre 1 et 40 %, de préférence entre 5 et 15 %, de la capacité nominale de l'accumulateur.

2. Procédé selon la revendication 1,
**caractérisé en ce que**
lors de l'évaluation de (LZ_{A}) on tient compte, en plus du débit de charge, du temps après le dernier calibrage.

3. Procédé selon les revendications 1 ou 2,
**caractérisé en ce que**
lors de l'évaluation de la deuxième valeur d'état de charge (LZ_{B}) on tient compte de la grandeur du courant s'écoulant encore lors de la détermination de Uo, un courant résiduel important conduisant à supposer une fiabilité plus faible.

4. Procédé selon une ou plusieurs des revendications 1 à 3,
**caractérisé en ce que**
lors de l'évaluation de la deuxième valeur d'état de charge (LZ_{B}) on tient compte de l'état de charge de l'accumulateur, et des états de charge entre 70 à 90 % et 30 à 40 % représentent une plus grande fiabilité que d'autres états de charge.
